(19) Europäisches Patentamt
European Patent Office
Office européen des brevets

(11) Veröffentlichungsnummer: **0 285 797**
**A2**

(12) # EUROPÄISCHE PATENTANMELDUNG

(21) Anmeldenummer: **88103001.9**

(51) Int. Cl.4: **G03F 7/10**

(22) Anmeldetag: **29.02.88**

(30) Priorität: **11.03.87 DE 3707841**

(43) Veröffentlichungstag der Anmeldung: **12.10.88 Patentblatt 88/41**

(84) Benannte Vertragsstaaten: **DE FR GB IT NL SE**

(71) Anmelder: **Siemens Aktiengesellschaft Berlin und München**
**Wittelsbacherplatz 2**
**D-8000 München 2(DE)**

(72) Erfinder: **Sezi, Recai, Dr.**
**Weiherstrasse 14**
**D-8551 Röttenbach(DE)**
Erfinder: **Feucht, Hans-Dieter, Dr.**
**Eschenweg 7**
**D-7253 Renningen 2(DE)**
Erfinder: **Birkle, Siegfried, Dr.**
**Veit-Stoss-Strasse 46**
**D-8552 Höchstadt(DE)**
Erfinder: **Leuschner, Rainer, Dr.**
**Gartenstrasse 29**
**D-8521 Grossenseebach(DE)**

(54) **Verfahren zur Erzeugung von Resiststrukturen.**

(57) Bei der Erzeugung von Resistrukturen nach der Zweilagen-Technik werden an siliciumhaltige Positivresists eine Reihe von Anforderungen gestellt. Das neue Verfahren soll unter anderem die Profilerhaltung bzw. die Maßhaltigkeit der Resiststrukturen gewährleisten.

Erfindungsgemäß werden als Resistmaterialien Vinylphenol-Vinylsilan-Copolymere folgender Struktur verwendet:

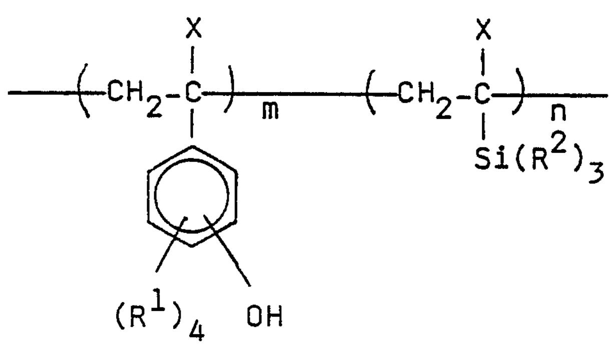

Bilevel-Resist

EP 0 285 797 A2

## Verfahren zur Erzeugung von Resiststrukturen

Die Erfindung betrifft ein Verfahren zur Erzeugung von Resiststrukturen auf der Basis siliciumhaltiger Positivresists und photoreaktiver Komponenten mittels UV-Strahlung.

Zur photolithographischen Erzeugung hochaufgelöster Strukturen (Submikrometerbereich) auf Substraten mit vorgegebener Topographie mußte bis vor einiger Zeit die sogenannte Dreilagen-Technik eingesetzt werden. Diese Technik ist aber sehr aufwendig und damit kostenintensiv, darüber hinaus ist sie nicht gut reproduzierbar, insbesondere infolge der unregelmäßigen Ausbildung der mittleren Schutzschicht.

In der Zwischenzeit wurden hochauflösende siliciumhaltige Positivresists entwickelt, die gegen reaktives Ionenätzen im Sauerstoffplasma beständig sind, d.h. die erforderliche $O_2$/RIE-Resistenz (RIE = Reactive Ion Etching) aufweisen. Mit derartigen Resists, sogenannten Bilevel-Resists, ist nun aber die Erzeugung hochaufgelöster Strukturen nach der Zweilagen-Technik möglich.

Ein siliciumhaltiger Bilevel-Resist ist beispielsweise aus der US-PS 4 521 274 bekannt. Dieser Resist ist ein Kondensationsprodukt von Formaldehyd mit einem mit Silicium substituierten Phenol, beispielsweise Trimethylsilylphenol, d.h. er ist ein siliciumhaltiger Phenol-Novolak. Der Resist kann auch in Form eines Terpolymers von Phenol, Trimethylsilylphenol und Formaldehyd vorliegen (siehe: "J. Vac. Sci. Technol.", Vol. B3, 1985, Seiten 306 bis 309).

Ein Si-haltiger Resist für Bilayer-Resistsysteme, d.h. für die Zweilagen-Technik, ist auch aus "J. Electrochem. Soc.", Vol. 132, 1985, Seiten 909 bis 913, bekannt. Dabei handelt es sich um ein partiell trimethylsilylmethyliertes Resorcin-Formaldehyd-Harz, d.h. um einen siliciumhaltigen Resorcin-Novolak.

Siliciumhaltige Positivresists der vorstehend genannten Art weisen neben der Beständigkeit gegen reaktives Ionenätzen im Sauerstoffplasma und dem hohen Auflösungsvermögen auch noch den Vorteil auf, daß sie alkalilöslich sind. Dies ist deshalb von Bedeutung, weil die Entwicklung dann wäßrig-alkalisch erfolgen kann, d.h. es kann auf die Verwendung organischer Entwickler verzichtet werden. Diese Eigenschaft weisen beispielsweise Positivresists in Form von Si-haltigen Polymethylmethacrylaten, wie sie aus der US-PS 4 481 049 bekannt sind, nicht auf, und auch nicht die aus der EP-PS 0 096 596 bekannten substituierte Silylreste aufweisenden Resists.

Für Bilayer-Resistsysteme ist ferner ein Positivresist auf der Basis von silyliertem Polystyrol bekannt, der Alkylsilyloxygruppen aufweist (siehe: A. Heuberger, H. Beneking "Microcircuit Engineering 84", Academic Press Inc., 1985, Seiten 471 bis 481). Dieser Resist weist - neben der Resistenz gegen reaktives Ionenätzen im Sauerstoffplasma - zwar auch die Eigenschaft der Alkalilöslichkeit auf, das Auflösungsvermögen entspricht aber nicht den gestellten Forderungen und der Kontrast (für UV-Licht) ist relativ gering, er liegt nämlich unter 2.

Die bekannten Si-haltigen Positivresists, die gegenüber energiereicher Strahlung empfindlich sind, weisen aber noch nicht alle geforderten Eigenschaften auf. Neben Resistenz gegen reaktives Ionenätzen im Sauerstoffplasma, hohem Auflösungsvermögen und Alkalilöslichkeit wird nämlich vor allem auch eine hohe Erweichungstemperatur gefordert. Eine hohe Erweichungstemperatur ist wichtig für die Profilerhaltung bzw. die Maßhaltigkeit der Resiststrukturen, und zwar sowohl beim Trocknungsprozeß als auch beim Ätzen im Sauerstoffplasma, weil dabei das Substrat, beispielsweise ein Wafer, aufgeheizt wird. Bei einer niederen Erweichungstemperatur, wie dies bei den bekannten Resists der Fall ist, erfolgt aber eine Abrundung der Resistkanten bereits bei relativ niedrigen Temperaturen.

Aufgabe der Erfindung ist es, ein Verfahren der eingangs genannten Art in der Weise auszugestalten, daß die Profilerhaltung bzw. die Maßhaltigkeit der Resiststrukturen gewährleistet ist, und das eingesetzte Resistmaterial dazu - neben Resistenz gegen reaktives Ionenätzen im Sauerstoffplasma, hohem Auflösungsvermögen und Alkalilöslichkeit - eine hohe Erweichungstemperatur aufweist.

Dies wird erfindungsgemäß dadurch erreicht, daß als Resistmaterial Vinylphenol-Vinylsilan-Copolymere folgender Struktur verwendet werden:

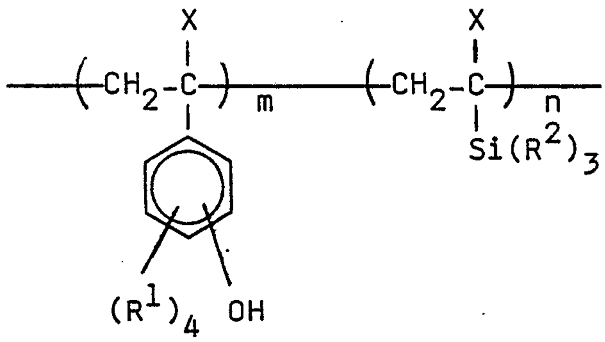

(I),

worin m + n = 1 ist und n maximal 0,55 beträgt,
und für die Reste X, $R^1$ und $R^2$ folgendes gilt:
X = H, $CH_3$, $C_2H_5$ oder Halogen (d.h. F, Cl, Br, J),
$R^1$ = H, $CH_3$, $C_2H_5$ oder Halogen,
$R^2$ = H, $CH_3$, $C_2H_5$, $C_3H_7$ oder $C_6H_5$,
und wobei die Reste X, $R^1$ und $R^2$ jeweils gleich oder verschieden sein können.

In der Formel I geben m und n die Zusammensetzung der Copolymeren als Stoffmengenanteil (Molenbruch) an. Der Anteil der Komponente n, d.h. des Vinylsilan-Grundbausteins, beträgt dabei maximal 0,55.

Die beim erfindungsgemäßen Verfahren eingesetzten Resistmaterialien weisen eine hohe Erweichungstemperatur auf, sie liegt nämlich über 155°C. Diese Resistmaterialien sind ferner alkalilöslich, d.h. bei ihrem Einsatz können handelsübliche wäßrige Entwickler verwendet werden. Darüber hinaus weisen die Resistmaterialien eine hohe Ätzresistenz im Sauerstoffplasma und auch eine hohe Auflösung auf. Zusammen mit photoreaktiven Komponenten ergeben die Resistmaterialien Positivresists, die gegenüber UV-Strahlung empfindlich sind. Dabei ist wesentlich, daß eine sehr gute Empfindlichkeit sowohl gegen normale UV-Strahlung (NUV, d.h. ca. 330 bis 440 nm) als auch gegen kurzwellige, d.h. Deep UV-Strahlung (DUV, d.h. < 300 nm) gegeben ist. Die (hohe) Empfindlichkeit gegenüber NUV (Near UV) ist deshalb von Bedeutung, weil dann die vorhandenen Belichtungseinrichtungen eingesetzt werden können, d.h. es sind für die Strukturerzeugung keine zusätzlichen Investitionen erforderlich. Im übrigen ist der Kontrast für UV-Strahlung sehr hoch, er liegt etwa bei 6. Im Vergleich dazu haben die bekannten silylierten Phenol-bzw. Resorcin-Novolake lediglich einen Kontrast von etwa 3.

Neben den bereits genannten Eigenschaften weist das beim erfindungsgemäßen Verfahren eingesetzte Resistmaterial auch noch die Vorteile einer reproduzierbaren Herstellung und einer hohen Lagerstabilität auf. Ferner ist wesentlich, daß dieses Material eine enge Molekulargewichtsverteilung hat, der Wert $M_w/M_n$ beträgt nämlich 1,2. Im übrigen weist das beim erfindungsgemäßen Verfahren als Resistmaterial dienende Vinylphenol-Vinylsilan-Copolymere ein Molekulargewicht etwa zwischen 500 und 50 000 auf; vorzugsweise liegt das Molekulargewicht im Bereich etwa zwischen 1000 und 5000.

Das Resistmaterial gemäß der Erfindung kann nicht nur bei der Bilevel-RIE-Technik eingesetzt werden, es kann vielmehr auch als Monolayer dienen. Der Siliciumanteil dieses Materials ist dabei in einem relativ großen Bereich beliebig variierbar. Bei der Verwendung als Bilevel-Resist liegt das Molverhältnis der beiden Copolymer-Grundbausteine Vinylphenol und Vinylsilan zwischen 85:15 und 45:55, d.h. das Resistmaterial weist mindestens 15 Mol-% und höchstens 55 Mol-% an der Vinylsilan-Komponente auf. Bei einem geringeren Gehalt an Silicium wäre nämlich einerseits die $O_2$/RIE-Resistenz zu gering, bei einem höheren Gehalt andererseits könnte nicht mehr wäßrig-alkalisch entwickelt werden. Bevorzugt liegt der Anteil an der Vinylsilan-Komponente etwa zwischen 30 und 50 Mol-% (bei der Verwendung des Copolymeren als Bilevel-Resist).

Beim erfindungsgemäßen Verfahren werden als Resistmaterial vorzugsweise Copolymere aus Vinylphenol und Vinyltrimethylsilan eingesetzt. Dem Resistmaterial wird eine photoreaktive Komponente zugesetzt, bevorzugt ein Chinondiazid, wie Naphthochinondiazid, d.h. eine chinoide Diazocarbonylverbindung.

Als Chinondiazide kommen insbesondere Umsetzungsprodukte folgender Verbindungen

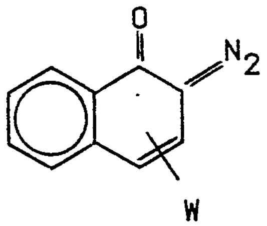 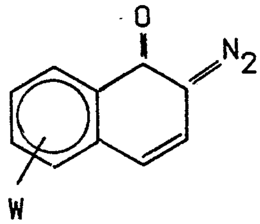 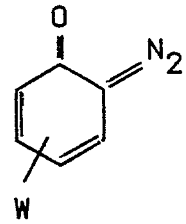 ,

wobei W = $-\underset{\underset{O}{\|}}{C}-Cl$ oder $-\overset{\overset{O}{\|}}{\underset{\underset{O}{\|}}{S}}-Cl$ ist,

mit aromatischen oder aliphatischen H-aciden Verbindungen, wie Alkoholen, Phenolen und Aminen, in Frage. Eine besonders ge eignete photoreaktive Komponente ist der 4-bzw. 5-Sulfonsäureester des Naphthochinondiazids mit mehrwertigen Phenolen, wie 2.3.4-Trihydroxybenzophenon und Bisphenol A.

Die Herstellung der beim erfindungsgemäßen Verfahren als Resistmaterialien eingesetzten Copolymeren erfolgt aus den entsprechenden Phenolethern (OR* anstelle von OH in Formel I). Diese Phenolether werden mit geeigneten Lewis-Säuren gespalten. Die Etherspaltung sowie die Herstellung der Phenolether-Copolymeren ist in der gleichzeitig eingereichten europäischen Patentanmeldung Nr. (VPA 87 P 3074 E), "Alkenylphenol-und Alkenylphenolether-Copolymere", beschrieben.

Anhand von Beispielen soll die Erfindung noch näher erläutert werden.

## Beispiel 1

Durch Mischen von 1 Gewichtsteil eines Esters, hergestellt aus 1 Mol 2.3.4-Trihydroxybenzophenon und 3 Mol 6-Diazo-5-oxo-5.6-dihydro-naphthalinsulfonylchlorid (hergestellt entsprechend US-PS 3 148 983), 3 Gewichtsteilen eines Copolymers bestehend aus 60 Mol-% p-Vinylphenol und 40 Mol-% Vinyltrimethylsilan (Molekulargewicht: ca. 2500), und 16 Gewichtsteilen Cyclohexanon wird eine Photoresistlösung hergestellt. Die fertige Lösung wird durch ein 0,2 µm-Filter filtriert und auf eine 4 Zoll-Siliciumscheibe (Wafer) aufgeschleudert (Dauer: 25 s); bei 3000 Umdrehungen pro Minute wird eine Schichtstärke von 0,9 µm erhalten. Anschließend wird im Umluftofen 30 min bei einer Temperatur von 90°C getrocknet. Danach wird mit einer Quecksilberlampe (Typ OSRAM HBO 350 W) 3 s durch eine Kontaktmaske belichtet und anschließend 45 s mit einem käuflichen alkalischen Entwickler ("Microposit Developer 303" der Fa. Shipley, verdünnt mit dem vierfachen Volumen an destilliertem Wasser) entwickelt. Dabei werden Strukturen im Submikrometerbereich erhalten, die während des Nachtrocknens bei 140°C/30 min keine Beeinträchtigung der Dimensionsgenauigkeit erfahren.

## Beispiel 2

Durch Mischen von 1 Gewichtsteil eines Esters, hergestellt aus 1 Mol 2.3.4-Trihydroxybenzophenon und 2 Mol 6-Diazo-5-oxo-5.6-dihydro-naphthalinsulfonylchlorid (siehe Beispiel 1), 3 Gewichtsteilen eines Vinylphenol-Vinyltrimethylsilan-Copolymers entsprechend Beispiel 1, und 16 Gewichtsteilen 2-Ethoxyethylacetat wird eine Photoresistlösung hergestellt. Die fertige Lösung wird durch ein 0,2 µm-Filter filtriert und auf eine 4 Zoll-Siliciumscheibe (Wafer) aufgeschleudert (Dauer: 25 s); bei 2000 Umdrehungen pro Minute wird eine Schichtstärke von 0,6 µm erhalten. Anschließend wird im Umluftofen 30 min bei einer Temperaur von 90°C getrocknet. Danach wird mit einer Quecksilberlampe (Typ OSRAM HBO 350 W) 2 s durch eine Kontaktmaske belichtet und anschließend 45 s mit einem käuflichen alkalischen Entwickler ("Microposit Developer 303", verdünnt mit dem zweifachen Volumen an destilliertem Wasser) entwickelt. Dabei werden Strukturen im Submikrometerbereich erhalten, die während des Nachtrocknens bei 140°C/30 min keine Beeinträchtigung der Dimensionsgenauigkeit erfahren.

Beispiel 3

Durch Mischen von 1 Gewichtsteil eines Esters, hergestellt aus 1 Mol Bisphenol A und 2 Mol 6-Diazo-5-oxo-5.6-dihydro-naphthalinsulfonylchlorid, 2 Gewichtsteilen eines Vinylphenol-Vinyltrimethylsilan-Copolymers entsprechend Beispiel 1, und 12 Gewichtsteilen Cyclohexanon wird eine Photoresistlösung hergestellt. Die fertige Lösung wird durch ein 0,2 µm-Filter filtriert und auf eine 4 Zoll-Siliciumscheibe (Wafer) aufgeschleudert (Dauer: 25 s); bei 3000 Umdrehungen pro Minute wird eine Schichtstärke von 0,9 µm erhalten. Anschließend wird im Umluft ofen 30 min bei einer Temperatur von 90°C getrocknet. Danach wird mit einer Quecksilberlampe (Typ OSRAM HBO 350 W) 10 s durch eine Kontaktmaske belichtet und anschließend 180 s mit einem käuflichen alkalischen Entwickler ("OFPR Developer NMD-3" der Fa. Dynachem) entwickelt. Dabei werden Strukturen im Submikrometerbereich erhalten, die während des Nachtrocknens bei 140°C/ 30 min keine Beeinträchtigung der Dimensionsgenauigkeit erfahren.

Beispiel 4

Auf eine 4 Zoll-Siliciumscheibe (Wafer) wird ein käuflicher NUV-Positivresist auf der Basis Novolak/Chinondiazid ("Microposit 1450 J" der Fa. Shipley) bei 3000 Umdrehungen pro Minute aufgeschleudert (Dauer: 25 s), dann wird 30 min bei 90°C getrocknet und anschließend 30 min bei 250°C im Umluftofen ausgeheizt. Nach dem Ausheizen beträgt die Schichtdicke des als Bottom-Resist dienenden Resists 2,2 µm.

Nun wird eine Resistlösung entsprechend Beispiel 1 bei 3000 Umdrehungen pro Minute auf den Bottom-Resist aufgeschleudert (Dauer: 25 s) und im Umluftofen 30 min bei 90°C getrocknet. Dabei erhält man einen 0,9 µm dicken Top-Resist, der auf dem Bottom-Resist gut haftet. Die Gesamtstärke des Zweilagen-Resists beträgt 3,1 µm.

Der Top-Resist wird dann mit einer Quecksilberlampe (Typ OSRAM HBO 350 W) 6 s durch eine Kontaktmaske belichtet und anschliessend 45 s mit dem Entwickler entsprechend Beispiel 1 entwickelt. Im Top-Resist werden dabei saubere Strukturen im Submikrometerbereich erhalten. Während des Nachtrocknens bei 140°C/ 30 min zeigen diese Strukturen keine Beeinträchtigung der Dimensionsgenauigkeit.

Die im Top-Resist erzeugte Struktur wird dann durch Reaktiv ionenätzen im Sauerstoffplasma (mit dem Reaktor AME 8111 der Fa. Applied Materials, Inc.) - Gasdruck: 0,7 Pa, Strömungsgeschwindigkeit: 35 sccm/min, Leistungsdichte: 0,2 W/cm² -in den Bottom-Resist übertragen; der Top-Resist dient dabei als Maske. Die Strukturübertragung erfolgt mit steilen Kanten.

**Ansprüche**

1. Verfahren zur Erzeugung von Resiststrukturen auf der Basis siliciumhaltiger Positivresists und photoreaktiver Komponenten mittels UV-Strahlung, **dadurch gekennzeichnet**, daß als Resistmaterial Vinylphenol-Vinylsilan-Copolymere folgender Struktur verwendet werden:

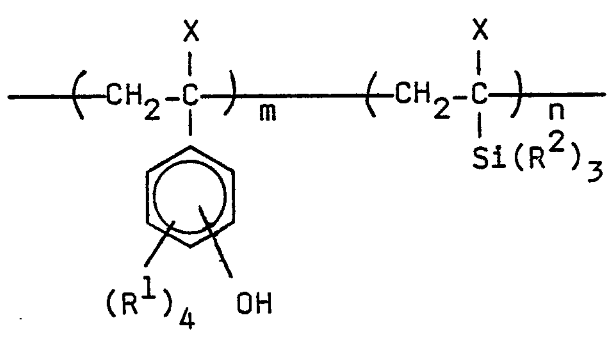
,

worin m + n = 1 ist und n maximal 0,55 beträgt,
und für die Reste X, $R^1$ und $R^2$ folgendes gilt:
X = H, $CH_3$, $C_2H_5$ oder Halogen (d.h. F, Cl, Br, J),
$R^1$ = H, $CH_3$, $C_2H_5$ oder Halogen,
$R^2$ = H, $CH_3$, $C_2H_5$, $C_3H_7$ oder $C_6H_5$,

und wobei die Reste X, $R^1$ und $R^2$ jeweils gleich oder verschieden sein können.

2. Verfahren nach Anspruch 1, **dadurch gekennzeichnet,** daß als Resistmaterial ein Copolymeres aus Vinylphenol und Vinyltrimethylsilan verwendet wird.

3. Verfahren nach Anspruch 1 oder 2, **dadurch gekennzeichnet,** daß dem Resistmaterial als photoreaktive Komponente ein Chinondiazid zugesetzt wird.